Europäisches Patentamt

European Patent Office

Office européen des brevets

(11) Numéro de publication: **0 097 067**
**A1**

(12)

# DEMANDE DE BREVET EUROPEEN

(21) Numéro de dépôt: **83400891.4**

(51) Int. Cl.³: **H 01 L 29/72, H 01 L 27/06**

(22) Date de dépôt: **03.05.83**

(30) Priorité: **14.05.82 FR 8208478**

(43) Date de publication de la demande: **28.12.83**
**Bulletin 83/52**

(84) Etats contractants désignés: **DE FR GB IT**

(71) Demandeur: **THOMSON-CSF, 173, Boulevard Haussmann, F-75379 Paris Cedex 08 (FR)**

(72) Inventeur: **Bouard, Philippe, THOMSON-CSF SCPI 173, bld Haussmann, F-75379 Paris Cedex 08 (FR)**

(74) Mandataire: **de Beaumont, Michel et al, THOMSON-CSF SCPI 173, Bld Haussmann, F-75379 Paris Cedex 08 (FR)**

(54) **Structure semi-conductrice de type mesa associant un transistor vertical et une diode en antiparallèle.**

(57) Dans cette structure, la métallisation (24) d'anode de la diode est distincte de la métallisation (23) d'émetteur du transistor. Seule la métallisation d'émetteur est reliée à une borne externe. La connexion entre ces métallisations se fait par l'intermédiaire d'un prolongement (22) de la couche $N^+$ d'émetteur (21). Il en résulte que, lors d'une inversion de tension quand la conduction de la diode s'arrête, la conduction du transistor démarre très rapidement en raison des charges injectées dans la diode qui sont alors récupérées par le transistor.

EP 0 097 067 A1

TITRE MODIFIÉ
voir page de garde

STRUCTURE SEMICONDUCTRICE DE TYPE MESA ASSOCIANT UNE DIODE
ET UN TRANSISTOR DE TYPES TRANSVERSES EN ANTIPARALLELE.

La présente invention concerne une structure semiconductrice de type mesa comprenant un transistor et une diode transverses en antiparallèle (on entend par composant transverse, un composant dont des électrodes principales se trouvent sur des faces opposées d'une pastille semiconductrice).

De telles associations d'un transistor et d'une diode montés en antiparallèle sont fréquentes dans de nombreuses applications, par exemple dans des circuits de balayage de télévision.

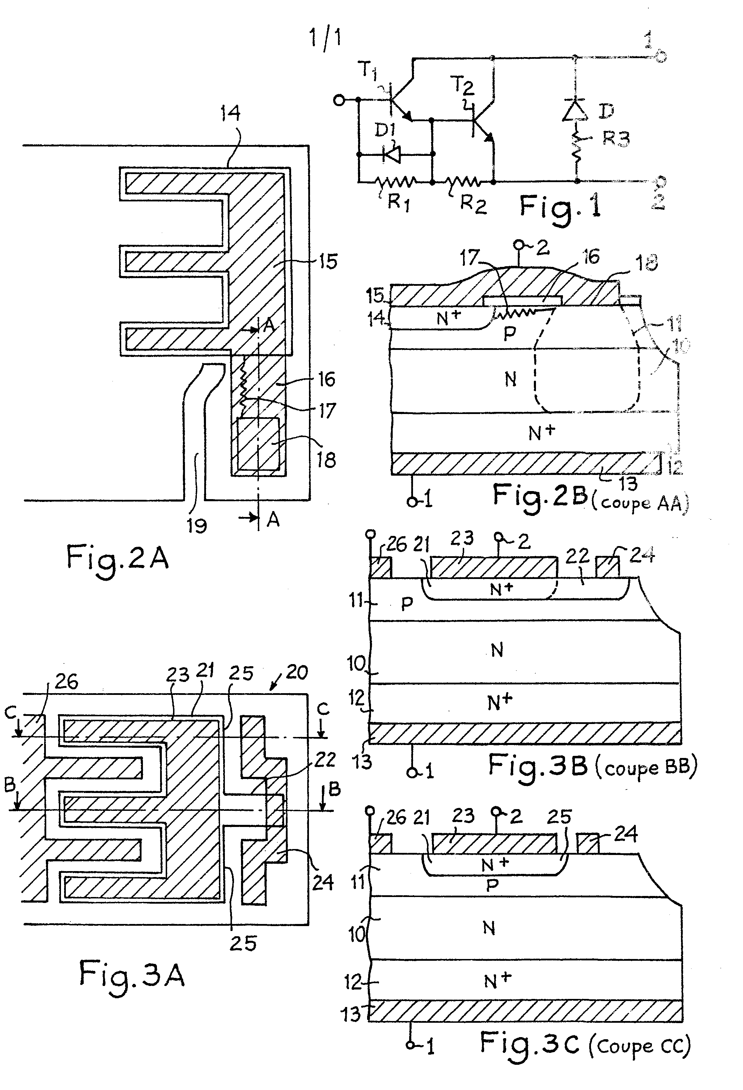

La figure 1 représente schématiquement un circuit que l'invention vise à réaliser sous forme intégrée. Ce circuit comprend un transistor T2 monté en antiparallèle avec une diode D entre des bornes 1 et 2, la borne 2 étant par exemple la masse. Dans l'exemple représenté, le transistor T2 est associé à un transistor de commande T1 selon un montage Darlington comprenant en outre des résistances R1 et R2 et une diode de déstockage D1.

On connaît dans la pratique de nombreux modes de réalisation intégrant dans une pastille semiconductrice unique l'ensemble du montage Darlington (T1, T2, D1, R1 et R2). Pour de nombreuses applications, par exemple pour des applications au balayage télévision, on souhaite que la diode D conduise tandis que la différence de potentiel entre les bornes 1 et 2 est négative, puis que le transistor T2 se mette à conduire quand cette différence de potentiel s'inverse. Plus particulièrement, on souhaite que cette transition entre la conduction de la diode et celle du transistor se fasse sans à-coups et que le transistor prenne pratiquement immédiatement lors de l'inversion de la tension, le relais de conduction de la diode. Pour cela, il faut que les porteurs injectés dans la zone semiconductrice correspondant à la diode soient très rapidement récupérés par le transistor quand celui-ci entre en conduction. Ceci pose un problème tout particulier lorsque l'on emploie les technologies de type mesa. Cette difficulté va être exposée en relation avec les figures 2A et 2B

2

qui représentent respectivement une vue de dessus et une vue en coupe partielles d'une structure de type mesa dans la région correspondant à l'émetteur du transistor T2 et à la diode.

En se référant plus particulièrement à la figure 2B, on rappelle qu'une structure de type mesa comprend sur un substrat 10 de type N, une couche 11 continue de type P formée par diffusion ou épitaxie (dans le cas d'une structure de type planar, la couche de type P peut comprendre plusieurs régions disjointes diffusées dans le substrat de type N). La deuxième face du substrat est revêtue d'une couche 12 de type $N^+$ à fort niveau de dopage, elle-même revêtue d'une métallisation 13 correspondant à la métallisation de collecteur du transistor T2 et de cathode de la diode D, connectée à la borne 1 de la figure 1. Dans la couche de type P 11 est diffusée une zone 14 de type $N^+$ correspondant à l'émetteur du transistor T2. Cette zone d'émetteur ainsi qu'une partie de la surface libre de la couche 11 de type P est revêtue d'une métallisation 15 connectée à la borne 2 de la figure 1. Dans la plupart des réalisations pratiques, la partie de la surface de la tranche semiconductrice voisine de la zone où la jonction $N^+P$ coupe la surface est protégée par une couche isolante d'oxyde de silicium 16 pour éviter de mettre la jonction en court-circuit. Néanmoins, la résistance 17 représentée en figure 2B a une très faible valeur si la zone correspondant au contact d'anode de la diode est proche de la zone correspondant au contact d'émetteur. En conséquence, la partie de l'émetteur se trouvant la plus proche de la diode sera pratiquement en court-circuit avec la région de base qui l'entoure et jouera un faible rôle lors du déclenchement du transistor. Dans ce cas, les charges injectées dans la région de la diode cernée dans la figure par un trait en pointillés, sont peu susceptibles d'aider au déclenchement du transistor puisqu'elles se trouvent proches d'une zone désensibilisée de la jonction émetteur/base de celui-ci. On se trouve donc devant le dilemme de rapprocher la zone de contact de diode de la zone d'émetteur pour que les porteurs injectés dans la diode soient proches du transistor, mais alors on désensibilise cette portion de la zone d'émetteur, ou bien d'éloigner la partie de diode de

3

l'émetteur pour éviter cette désensibilisation, mais alors les porteurs injectés dans la région de diode se trouvent trop loin de la région d'émetteur par rapport à la longueur de diffusion pour contribuer à l'initialisation de la conduction du transistor.

Dans la vue de dessus de la figure 2A, on a représenté seulement la portion d'émetteur du transistor T2, sous forme d'une région digitée 14. La métallisation 15 recouvre l'émetteur et la zone apparente 18 de type P où se fait le contact avec l'anode de la diode. Pour éviter de désensibiliser trop fortement l'émetteur, on creuse dans la couche 11 un sillon 19 cernant la région 18 où se trouve le contact de la diode.

Ainsi, la configuration de la figure 2A représente un exemple très schématique d'un compromis possible pour disposer l'émetteur du transistor T2 et l'anode de la diode D de façon à pouvoir récupérer pour le déclenchement du transistor une partie des porteurs injectés dans la région de diode lors de la conduction de celle-ci. Mais ce compromis n'a pas donné de résultats très satisfaisants pour les raisons exposées précédemment.

Ainsi, la présente invention vise une nouvelle structure associant un transistor et une diode de types transverses montés en antiparallèle dans une structure mesa. L'objet essentiel de la présente invention est de permettre une bonne utilisation des porteurs injectés lors de la conduction de la diode pour aider au déclenchement du transistor lors d'une mise en conduction de celui-ci.

Pour atteindre cet objet, la présente invention prévoit une structure semiconductrice de type mesa comprenant un transistor et une diode transverses en antiparallèle constituée à partir d'un substrat d'un premier type de conductivité revêtu sur sa face supérieure d'une couche continue du deuxième type de conductivité dans une partie de laquelle est formée une zone du premier type de conductivité correspondant à l'émetteur du transistor et recouverte d'une première métallisation reliée à une borne externe, une deuxième métallisation recouvrant une partie de la couche du deuxième type de conductivité le long d'une limite de la zone du premier type de conductivité, cette deuxième métallisation étant reliée à la première métallisation par l'intermédiaire d'une résistance de liaison de valeur choisie. Cette résistance de liaison est constituée par un prolongement de la zone du premier type de conductivité non recouvert par la première métallisation et atteignant la deuxième métallisation. De préférence, la deuxième métallisation s'écarte de la limite de la zone du premier type de conductivité à l'emplacement où elle est rejointe par le prolongement de cette zone.

Ces objets, caractéristiques et avantages ainsi que d'autres de la présente invention seront exposés plus en détail dans la description suivante de modes de réalisation particuliers faite en relation avec les figures jointes parmi lesquelles :

- la figure 1 représente un schéma de transistor à diode antiparallèle,

- les figures 2A et 2B représentent des vues partielles, de dessus et en coupe d'une structure de transistor à diode antiparallèle selon l'art antérieur,

- les figures 3A à 3C représentent une vue de dessus et des vues en coupe d'une partie d'une structure associant en antiparallèle un transistor et une diode selon la présente invention.

De façon générale, on notera que dans les diverses figures représentées, aucune échelle n'est respectée, ni à l'intérieur d'une même figure, ni d'une figure à l'autre ; au contraire, selon l'usage dans le domaine de la représentation des semiconducteurs, certaines dimensions ont été artificiellement dilatées ou rétrécies pour faciliter la lisibilité de ces figures.

La figure 3A représente en vue de dessus un mode de réalisation de la présente invention. Les figures 3B et 3C sont des vues en coupe selon les lignes B-B et C-C indiquées en figure 3A. Sur une pastille de silicium 20 de type mesa comprenant, comme celle de l'art antérieur, des couches uniformes 10 de type N, 11 de type P, 12 de type $N^+$ ainsi qu'une métallisation 13, est formée une zone de type $N^+$ comprenant une partie principale 21 et un prolongement 22. La zone 21 correspond à l'émetteur d'un transistor, par exemple le transistor principal T2 d'un montage Darlington tel

5

que représenté en figure 1. Diverses configurations d'émetteur peuvent être utilisées comme cela est connu dans la technique. La partie d'émetteur proprement dite 21 est recouverte d'une métallisation 23 connectée à la borne 2 de la figure 1. Une partie extrême du prolongement 22 de la diffusion de type N$^+$ 21 est recouverte par une métallisation 24 qui s'étend par ailleurs parallèlement à une frontière 25 de la zone d'émetteur 21. De préférence, la frontière 25 concernée est éloignée des zones frontières de la couche d'émetteur qui se trouvent voisines de la métallisation de base 26 représentée sous forme digitée à la partie gauche de la figure. On rappellera que cette métallisation de base peut être connectée à une borne externe si l'émetteur 21 correspond à un transistor isolé ou bien être connectée à la métallisation d'émetteur d'un transistor Tl disposé sur la même pastille de silicium 20 dans le cas d'un montage Darlington.

Le fonctionnement du dispositif selon l'invention va être explicité en se référant aux figures 3 et à la figure 1. Selon une caractéristique importante de l'invention, la métallisation 24 qui correspond à l'anode de la diode D n'est pas reliée directement à la borne 2 et à la métallisation d'émetteur 23 du transistor T2. Au contraire, cette connection se fait par l'intermédiaire d'une résistance constituée par la partie en prolongement 22 de la zone d'émetteur 21. La valeur de cette résistance peut être choisie en fonction de la forme de ce prolongement 22. Il en résulte que la partie de la métallisation 24 se trouvant en regard de la frontière 25 de la zone d'émetteur 21 peut être très proche de cette zone sans qu'il se produise une désensibilisation de cette partie de l'émetteur étant donné l'existence d'une résistance non négligeable et donc d'une chute de potentiel entre les métallisations en regard 24 et 23. La distance qu'auront à parcourir les porteurs injectés dans la diode pour atteindre la jonction émetteur/base du transistor pourra donc être nettement inférieure à la longueur de diffusion dans la couche 11.

On notera que la présence de la partie en prolongement 22 recouverte par la métallisation 24 équivaut à l'insertion d'une

6

résistance R3 entre l'anode de la diode D et la borne 2. Ceci entraîne que, lorsque la diode D est conductrice, il va exister une chute de tension en direct plus importante que dans le cas de l'art antérieur. Ainsi, la présente invention ne présente pas d'intérêt pour n'importe quelle application, mais plus particulièrement pour des applications dans lesquelles on souhaite que les charges injectées dans la zone semiconductrice correspondant à la diode D puissent être récupérées lors d'une commutation pour assister à l'initialisation de la conduction d'un transistor voisin T2. Ceci est notamment le cas dans les applications du type balayage de télévision.

La présente invention n'est pas limitée aux modes de réalisation explicitement décrits ; au contraire, elle en englobe les diverses variantes et généralisations incluses dans le domaine des revendications ci-après.

7

REVENDICATIONS.

1. Structure semiconductrice de type mesa comprenant un transistor et une diode transverses en antiparallèle constituée à partir d'un substrat (10, 12) d'un premier type de conductivité revêtu sur sa face supérieure d'une couche continue (11) du deuxième type de conductivité dans une partie de laquelle est formée une zone (21) du premier type de conductivité correspondant à l'émetteur du transistor, et recouverte d'une première métallisation (23) reliée à une borne externe (2) ; caractérisée en ce qu'elle comprend en outre une deuxième métallisation (24) correspondant à une borne de la diode recouvrant une partie de la couche (11) du deuxième type de conductivité le long d'une limite (25) de la zone du premier type de conductivité, cette deuxième métallisation étant reliée à la première métallisation par l'intermédiaire d'une résistance de liaison de valeur choisie.

2. Structure semiconductrice de type mesa selon la revendication 1, caractérisée en ce que la résistance de liaison est constituée par un prolongement (22) de la zone du premier type de conductivité non recouvert par la première métallisation et atteignant la deuxième métallisation.

3. Structure semiconductrice de type mesa selon la revendication 2, caractérisée en ce que la deuxième métallisation s'écarte de la limite de la zone du premier type de conductivité à l'emplacement où elle est rejointe par le prolongement de cette zone.

4. Structure semiconductrice de type mesa selon la revendication 1, caractérisée en ce que le transistor est un transistor principal (T2) d'un montage de type Darlington.

Fig.1

Fig.2A

Fig.2B (coupe AA)

Fig.3A

Fig.3B (coupe BB)

Fig.3C (Coupe CC)

Office européen
des brevets

**RAPPORT DE RECHERCHE EUROPEENNE**

0097067

Numéro de la demande

EP 83 40 0891

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| A | COMPONENTS REPORT, vol. 11, no. 1, mars 1976, pages 20-23, Munich, DE. M. ARTL et al.: "H-deflection transistor with integrated deflection diode" * Page 20; figures 1-3 * | 1,2 | H 01 L 29/72 H 01 L 27/06 |
| | --- | | |
| A | FR-A-2 160 545 (RCA) * Page 4, lignes 9-37; figure 4 * | 1,2 | |
| | --- | | |
| A | US-A-3 877 059 (MOTOROLA) * Colonne 5, lignes 1-8; figures 1-3 * | 1 | |
| | ----- | | |

DOMAINES TECHNIQUES RECHERCHES (Int. Cl. ³)

H 01 L

Le présent rapport de recherche a été établi pour toutes les revendications

| Lieu de la recherche | Date d'achèvement de la recherche | Examinateur |
|---|---|---|
| LA HAYE | 20-07-1983 | PELSERS L. |